# EUROPEAN PATENT APPLICATION

(11) **EP 4 625 824 A1**
(43) Date of publication of application: **01.10.2025**
(21) Application number: 25159290.3
(22) Date of filing: 21.02.2025
(51) Int. Cl.: H03M 1/20, H03M 1/36

(54) **FLASH ADC COMPARATOR INTERPOLATION**

(30) Priority: 26.03.2024 US 202418616729
(71) Applicant: INTEL Corporation, Santa Clara, CA 95054 (US)
(72) Inventor: KRUPNIK, Yoel, 96920 Jerusalem (IL); NASHASH, Mohammad, 9701714 Jerusalem (IL); LOTAN, Idan, 6094600 Bitzaron (IL); COHEN, Ariel, 71799 Modiin-Makkabbim-Reut (IL)
(74) Representative: HGF

(57) **Abstract**

An analog-to-digital converter (ADC) circuit includes a first comparator circuit, a second comparator circuit, and an interpolation circuit. The first comparator circuit includes a first input terminal to receive a first reference voltage signal and a second input terminal to receive an input voltage signal. The second comparator circuit includes a first input terminal to receive a second reference voltage signal and a second input terminal to receive the input voltage signal. The interpolation circuit includes a first input terminal coupled to a first output terminal of the first comparator and a second input terminal coupled to a first output terminal of the second comparator.

## Description

### BACKGROUND

High-speed analog-to-digital converters (ADCs) play a crucial role in multi-gigabit serial data links used in technologies such as peripheral component interface (PCI) express, Ethernet, and more. These technologies are central to the development of modern computer systems for data centers and cloud computing. However, existing implementations of ADC units can have drawbacks associated with resolution, conversion time, power, and input load.

### BRIEF DESCRIPTION OF THE DRAWINGS

In the drawings, like numerals may describe the same or similar components or features in different views. Like numerals having different letter suffixes may represent different instances of similar components. Some embodiments are illustrated by way of example, and not limitation, in the figures of the accompanying drawings in which:
FIG. 1 is a block diagram of a flash ADC;
FIG. 2A is a block diagram of a 3-bit comparator (8-level) flash ADC using 7 comparators;
FIG. 2B is a block diagram of a 3-bit comparator (8-level) flash ADC using 4 comparators and 3 interpolation circuits, in accordance with some embodiments;
FIG. 3 is a block diagram of an interpolation slice including 2 comparators and an interpolation circuit, in accordance with some embodiments;
FIG. 4 is a block diagram of an example comparator that can be used by the flash ADC of FIG. 2B, in accordance with some embodiments;
FIG. 5 illustrates graphical representations associated with comparator output delay, in accordance with some embodiments;
FIG. 6 is a block diagram of an example adjustable delay circuit that can be used by the flash ADC of FIG. 2B, in accordance with some embodiments;
FIG. 7, FIG. 8, FIG. 9, FIG. 10, and FIG. 11 illustrate graphical representations of simulation results associated with the flash ADC of FIG. 2B, in accordance with some embodiments;
FIG. 12 is a flow diagram of an example method for generating differential output signals by an interpolation slice of an ADC, in accordance with some embodiments; and
FIG. 13 illustrates a block diagram of an example machine upon which any one or more of the operations/techniques (e.g., methodologies) discussed herein may perform.

### DETAILED DESCRIPTION

The following detailed description refers to the accompanying drawings. The same reference numbers may be used in different drawings to identify the same or similar elements. In the following description, for purposes of explanation and not limitation, specific details are set forth, such as particular structures, architectures, interfaces, techniques, etc., to provide a thorough understanding of the various aspects of various embodiments. However, it will be apparent to those skilled in the art having the benefit of the present disclosure that the various aspects of the various embodiments may be practiced in other examples that depart from these specific details. In certain instances, descriptions of well-known devices, circuits, and methods are omitted so as not to obscure the description of the various embodiments with unnecessary detail.

The following description and the drawings sufficiently illustrate specific embodiments to enable those skilled in the art to practice them. Other embodiments may incorporate structural, logical, electrical, process, and other changes. Portions and features of some embodiments may be included in or substituted for those of other embodiments. Embodiments outlined in the claims encompass all available equivalents of those claims.

As used herein, the term "chip" (or die) refers to a piece of a material, such as a semiconductor material, that includes a circuit, such as an integrated circuit or a part of an integrated circuit. The term "memory IP" indicates memory intellectual property. The terms "memory IP," "memory device," "memory chip," and "memory" are interchangeable.

The term "a processor" configured to carry out specific operations includes both a single processor configured to carry out all of the operations (e.g., operations or methods disclosed herein) as well as multiple processors individually configured to carry out some or all of the operations (which may overlap) such that the combination of processors carry out all of the operations.

The disclosed techniques include an ADC implementation using a reduced number of comparators in combination with interpolation circuits, which reduces the conversion time, load, power, and circuit area. More specifically, the disclosed ADC implementation is based on configuring the interpolation of adjacent comparators by an interpolation circuit (e.g., an SR latch) that is connected to the comparators' outputs. The interpolation takes advantage of the comparator delay that depends on the input signal level, where the interpolation circuit determines which comparator comes earlier. This decreases the number of comparators by half compared to a conventional flash ADC.

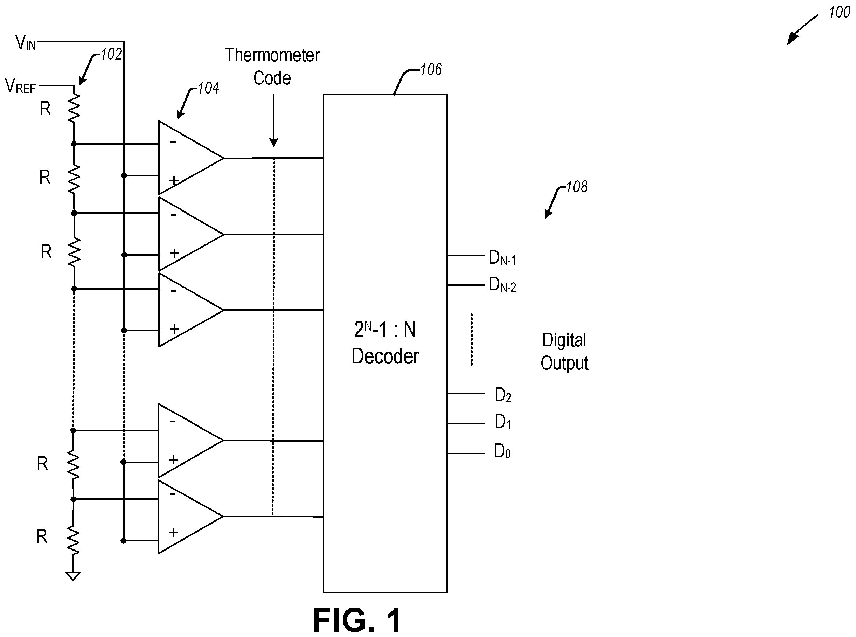

FIG. 1 is a block diagram of a flash ADC 100. Referring to FIG. 1, the flash ADC 100 includes a plurality of comparators 104 (e.g., 2ⁿ-1 comparators), a reference generation circuit 102 generating 2n-1 reference voltages (e.g., based on reference voltage signal Vref), and a thermometer-to-binary decoder 106, which generates digital output 108 based on the comparator output and the thermometer code.

In some aspects, the number of comparators can become an issue exponentially fast as the number of bits of the ADC is increased, which impacts the input load and power of the flash ADC. The input load of the ADC can be critical and determines the ADC bandwidth.

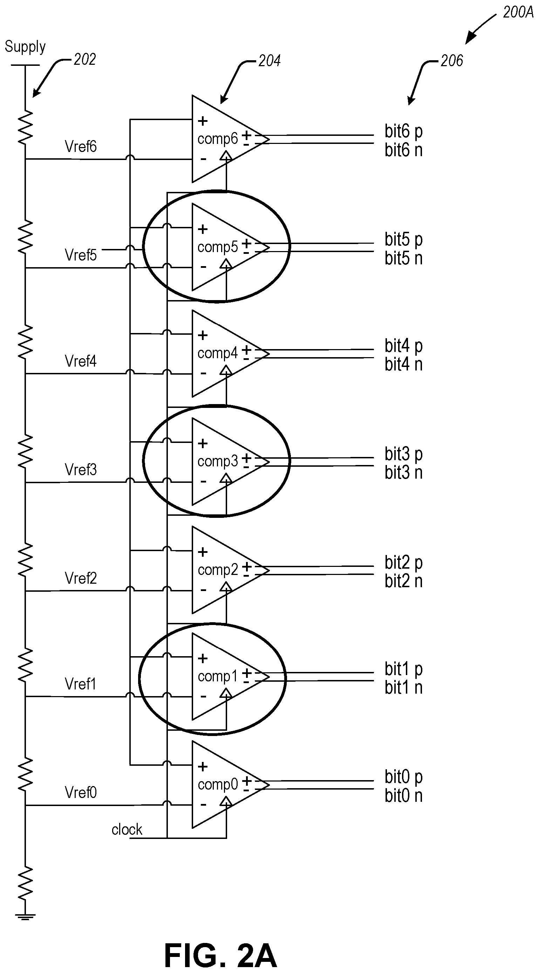

FIG. 2A is a block diagram of a 3-bit comparator (8-level) flash ADC 200A using 7 comparators. Referring to FIG. 2A, ADC 200A includes reference generation circuit 202 and comparators 204. Comparators 204 generate digital output signals 206 (e.g., each comparator can generate a set of differential output signals designated in FIG. 2A as bitX p and bitX n).

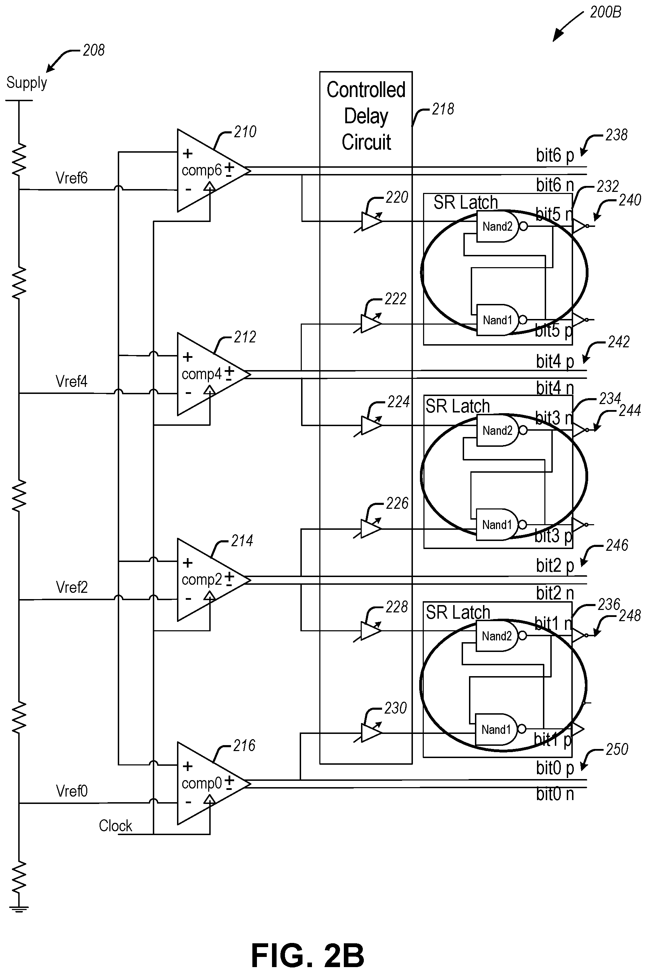

FIG. 2B is a block diagram of a 3-bit comparator (8-level) flash ADC 200B using 4 comparators and 3 interpolation circuits, in accordance with some embodiments. Referring to FIG. 2B, ADC 200B includes reference generation circuit 208, comparators 210, 212, 214, and 216, controlled delay circuit 218, and interpolation circuits 232, 234, and 236. In some aspects, interpolation circuits 232, 234, and 236 include SR latches.

Comparators 210-216 and interpolation circuits 232-236 generate digital output signals 238, 240, 242, 244, 246, 248, and 250 (e.g., each comparator and each interpolation circuit can generate a set of differential output signals designated in FIG. 2B as bitX p and bitX n).

In some aspects, the controlled delay circuit 218 includes adjustable delay circuits 220, 222, 224, 226, 228, and 230. As illustrated in FIG. 2B, each of adjustable delay circuits 220-230 is coupled to an output of one of the comparators and an input of one of the interpolation circuits.

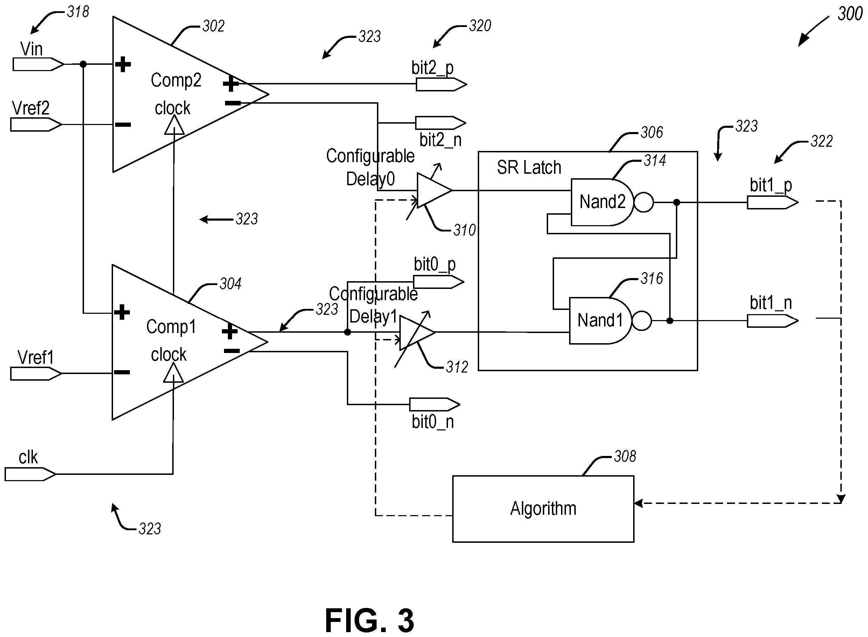

In some aspects, the delay associated with each of the adjustable delay circuits 220, 222, 224, 226, 228, and 230 is configured (e.g., by a processor, as illustrated in FIG. 3) so that the output signal generated by the corresponding interpolation circuit is centered between the reference voltage signals supplied to the corresponding two comparators associated with the interpolation circuit. For example, the delay of adjustable delay circuit 220 is configured so that the differential output signal bit5_n generated by interpolation circuit 232 turns to logic "0" when input is between Vref4 and Vref6.

The disclosed techniques can be used to configure ADC 200B (which uses 4 comparators and 4 reference voltages) to replace ADC 200A (which uses 7 comparators and 7 reference voltages). More specifically, ADC 200B can be configured by replacing 3 comparators with 3 interpolation circuits and including a controlled delay circuit 218. In this regard, ADC 200B uses interpolation circuits 232-236, which are associated with the following advantages: the interpolation circuits occupy a smaller area than the comparators they replace, have a smaller load on the analog input signal, take less power, do not use reference voltages, and do not use clock signals.

In this regard, an ADC can be configured using multiple interpolation slices where an even number of comparators is interpolated by at least one interpolation circuit to obtain at least one additional set of differential output signals. An example interpolation slice, including two comparators and an interpolation circuit, is illustrated in FIG. 3.

FIG. 3 is a block diagram of an interpolation slice 300, including 2 comparators and an interpolation circuit, in accordance with some embodiments. Referring to FIG. 3, interpolation slice 300 includes reference generation circuit 318, comparators 302 and 304, adjustable delay circuits 310 and 312, an interpolation circuit 306, and an algorithm 308. In some aspects, interpolation circuit 306 is an SR latch, which includes NAND gates 314 and 316.

In operation, reference generation circuit 318 supplies reference voltage signals (e.g., Vref1 and Vref2) and an input voltage signal (e.g., Vin) to comparators 302 and 304 (which also receive a clock signal clk). Comparators 302 and 304 generate differential output signals 320 (e.g., bit0_n, bit0_p, bit2_n, and bit2_p). Differential signals bit2_n and bit0_p are supplied to respective adjustable delay circuits 310 and 312. The delayed signal outputs from adjustable delay circuits 310 and 312 are supplied to the inputs of the interpolation circuit 306 (e.g., to corresponding NAND gates 314 and 316). The interpolation circuit 306 generates differential output signals 322 (e.g., signals bit1_p and bit1_n).

As illustrated in FIG. 3, the components of the interpolation slice can be coupled to each other by interconnects 323.

In some aspects, the delay associated with each of the adjustable delay circuits 310 and 312 is configured (e.g., by the algorithm 308) so that the output signal generated by the corresponding interpolation circuit is centered between the reference voltage signals supplied to the corresponding two comparators associated with the interpolation circuit. For example, the delay of adjustable delay circuit 310 (also referred to as delay0) is configured so that the differential output signal bit1_p generated by interpolation circuit 306 is centered between Vref1 and Vref2. Similarly, the delay of adjustable delay circuit 312 (also referred to as delay1) is configured so that the differential output signal bit1_n generated by interpolation circuit 306 turns to logic "0" when the input is centered between Vref1 and Vref2.

In some aspects, algorithm 308 can be implemented by a function, a look-up table (LUT), or a state machine. In some aspects, algorithm 308 is configured using a processor. In some aspects, algorithm 308 receives as inputs the flash ADC outputs. Algorithm 300 then performs a process of computation to estimate the ranges of the inputs of the flash ADC for which the outputs are giving a certain output. The algorithm 308 then performs the function outputs, which are configured as the digital controls of the delay elements. In this regard, algorithm 308 is configured as a feedback loop, that corrects errors in the ranges of the flash ADC.

In some aspects, algorithm 308 includes delay calibration logic to offset the device and layout mismatches across process-volt-temperature (PVT).

In some aspects, when the clock signal clk is reset, both positive and negative polarity outputs (e.g., <sig>_p and <sig>_n) are zero. After the clock signal rises, one of the complementary outputs can be set to logic1, according to the comparison result.

In some aspects, comparator 304 (also referred to as Comp1) is a dynamic comparator. When clk is logic0, bit0_p and bit0_n would be logic0. On the clk rising edge:
(a) if Vin > Vref1, then bit0_p will turn to logic1 and bit0_n will remain logic0; and
(b) if Vin < Vref1, then bit0_n will turn to logic1 and bit0_p will remain logic0.

In some aspects, comparator 302 (also referred to as Comp2) is a dynamic comparator. When clk is logic0, bit2_p and bit2_n would be logic0. On the clk rising edge:
(a) if Vin > Vref2, then bit2_p will turn to logic1 and bit2_n will remain logic0; and
(b) if Vin < Vref2, then bit2_n will turn to logic1 and bit2_p will remain logic0.

The operation of the interpolation slice 300 can be summarized as follows. Reference voltages are configured so that Vref1 < Vref2. The following processing case scenarios can be observed (after the clk rising edge):
(A) When Vin < Vref1: The signals bit0_p, bit1_p, bit2_p would be settled to logic1 (signals bit2_p and bit0_p due to the operation of the comparators, and bit1_p due to the operation of the SR latch).
(B) When Vin >Vref2: The signals bit0_p, bit1_p, bit2_p would be settled to logic0 (outputs bit2_p and bit0_p due to the operation of the comparators, and bit1_p due to the operation of the SR latch).
(C) When Vref1 < Vin < Vref2: The signals bit0_p and bit2_n would be settled to 1. The order in time in which signals bit0_p and bit2_n change determines the bit1_p logic value. If bit0_p rises earlier than bit2_n, the SR latch would be set, and bit1_p would become logic1. If bit2_n rises earlier than bit0_p, the SR latch would be reset, and bit1_p would become logic0.

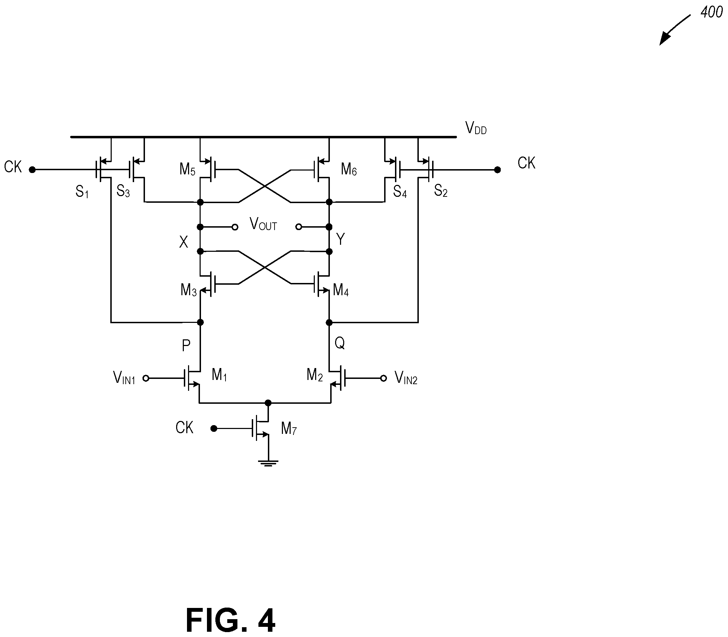

In some aspects, comparators 302 and 304 are dynamic comparators with the following property: the delay between the clock's rising edge and the assertion of one of its outputs increases as |Vin-Vref| is closer to 0. The strongarm comparator (e.g., as illustrated in FIG. 4) is an example of such a dynamic comparator, but other types of comparators can be used as well.

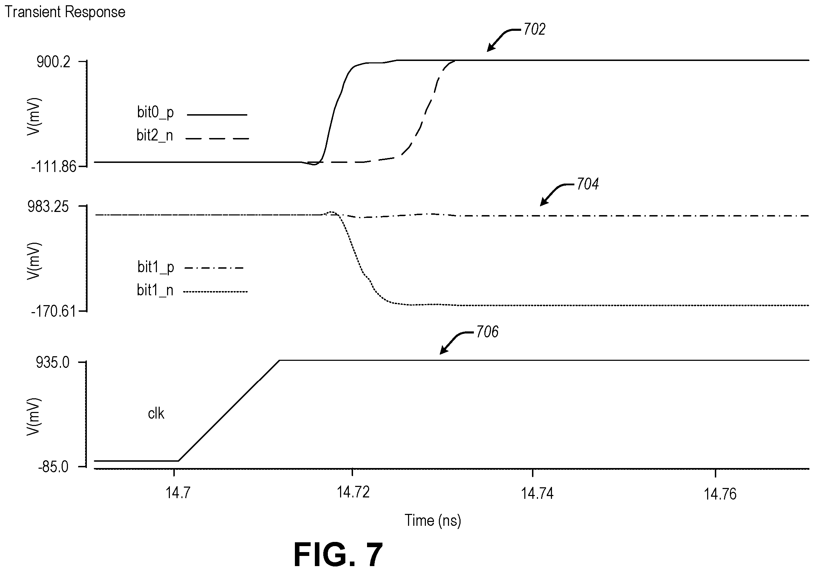

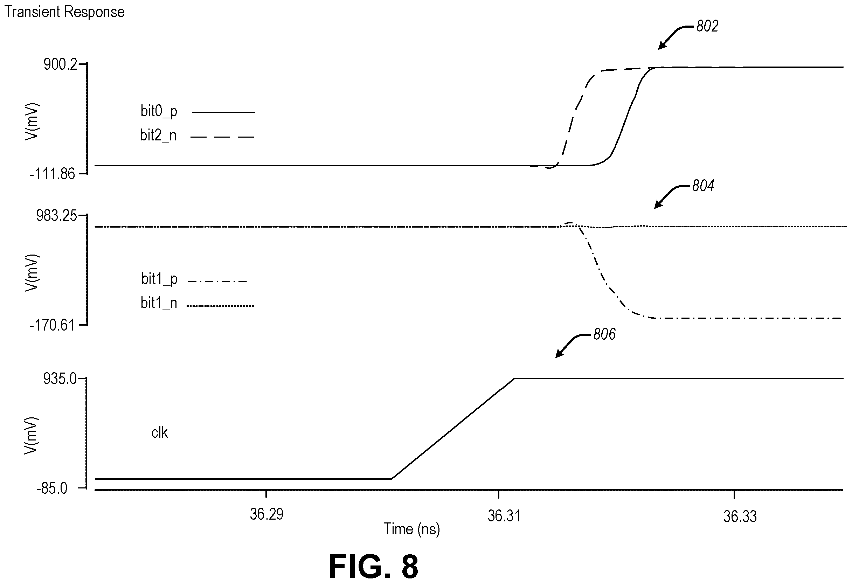

If the two comparators are identical:
(D) If |Vin-Vref1| < |Vin-Vref2|, then bit2_n rises earlier than bit0_p, so bit1_p is set to logic0 (e.g., as illustrated in FIG. 8).
(E) If |Vin-Vref2| < |Vin-Vref1|, the order of change will be reversed, and bit1_p is set to logic1 (as illustrated in FIG. 7).

In this regard, bit1_p is logic0 if Vref1 < Vin < (Vref1+Vref2)/2 and logic1 if (Vref1+Vref2)/2 < Vin < Vref2.

In some aspects, programmable delay units delay0 and delay1 mitigate the mismatch between the comparators. When the delay of delay0 increases, it moves the decision point of 'bit1_p' to Vref2; when delay2 increases, it moves the decision level to Vref1.

FIG. 4 is a block diagram of an example strongarm comparator 400 that can be used by the flash ADC of FIG. 2B, in accordance with some embodiments. The comparator's dynamic behavior stems from the regenerative circuit (illustrated in FIG. 4), which is triggered by the clock going high and then using the back-to-back inverters as a positive feedback loop.

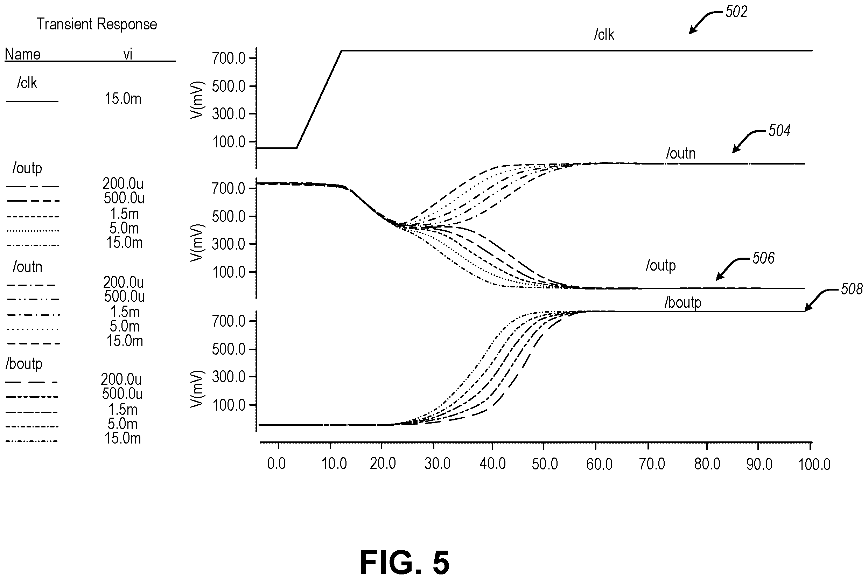

FIG. 5 illustrates graphical representations (or graphs) 502, 504, 506, and 508 associated with comparator output delay, in accordance with some embodiments. More specifically, graph 502 is the clk signal, graph 504 is the out_n (-) waveform of the comparator, graph 506 is the out_p (+) waveform of the comparator, and graph 508 is the buffered output waveform of the comparator.

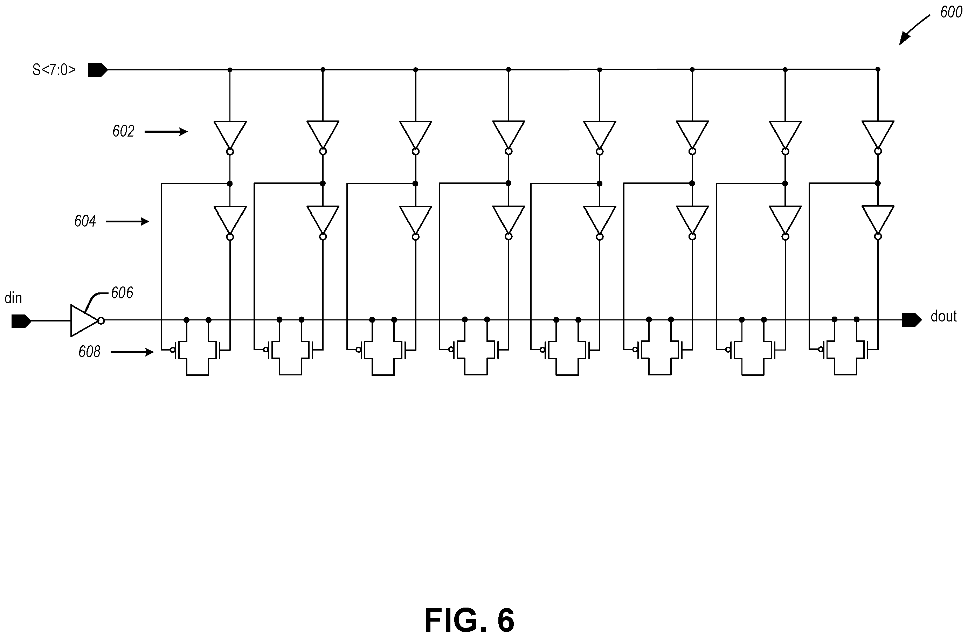

FIG. 6 is a block diagram of an example adjustable delay circuit 600 that can be used by the flash ADC of FIG. 2B, in accordance with some embodiments. Referring to FIG. 6, the adjustable delay circuit 600 includes an inverter driving a digitally programmable load. More specifically, the adjustable delay circuit 600 includes a first set of inverters 602, a second set of inverters 604, an input inverter 606, and a set of NMOS-PMOS transistor pairs 608.

In some aspects, the programmable (configurable) delay provided by the adjustable delay circuit 600 compensates for mismatch due to devices, layout, and PVT associated with the interpolation slice.

FIG. 7, FIG. 8, FIG. 9, FIG. 10, and FIG. 11 illustrate graphical representations of simulation results associated with the flash ADC of FIG. 2B, in accordance with some embodiments.

FIG. 7 includes graphs 702, 704, and 706 associated with a processing configuration where bit0_p is asserted after bit2_n, sending bit1_p to logic0 and indicating that Vref1 < Vin < (Vref1+Vref2)/2.

FIG. 8 includes graphs 802, 804, and 806 associated with a processing configuration where bit2_n is asserted after bit0_p, keeping bit1_p at logic1 and indicating that (Vref1+Vref2)/2 < Vin < Vref2.

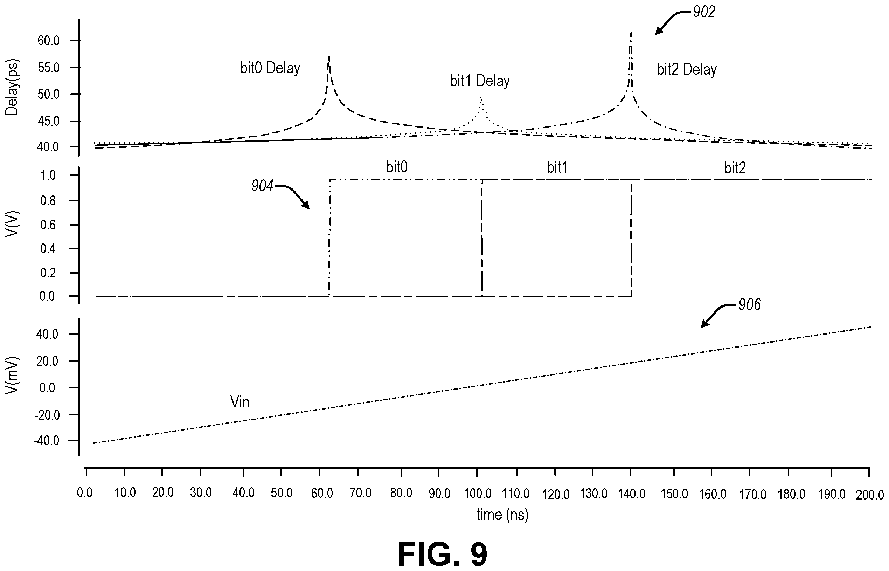

FIG. 9 includes graphs 902, 904, and 906 associated with simulation results of the interpolation slice, consisting of 2 comparators and 1 interpolation circuit (as illustrated in FIG. 2B). FIG. 9 illustrates the values of the slice output - bit0, bit1, bit2 and their delays relative to the input clock as a function of input voltage.

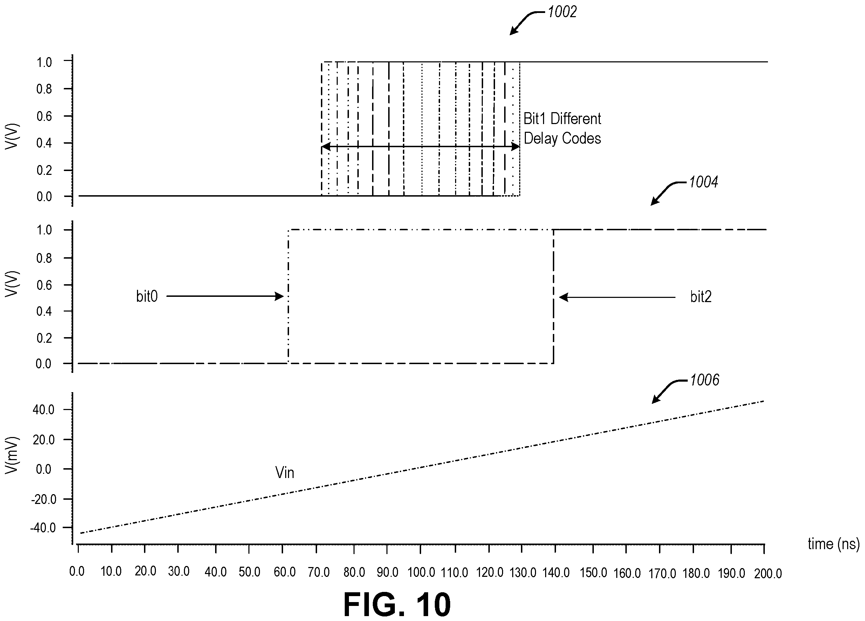

FIG. 10 includes graphs 1002, 1004, and 1006, associated with calibration offsets with different calibration codes.

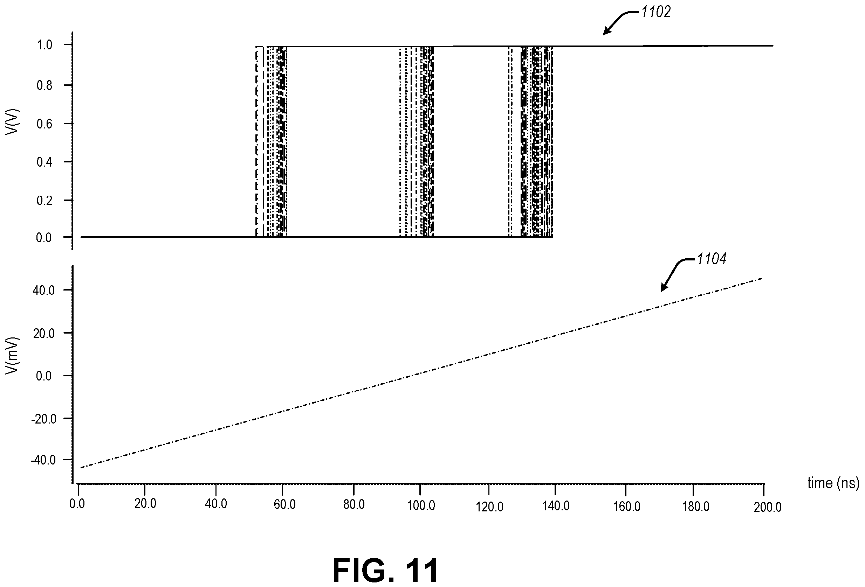

FIG. 11 includes graphs 1102 and 1104 associated with the simulation of an interpolation slice with 40 process corners.

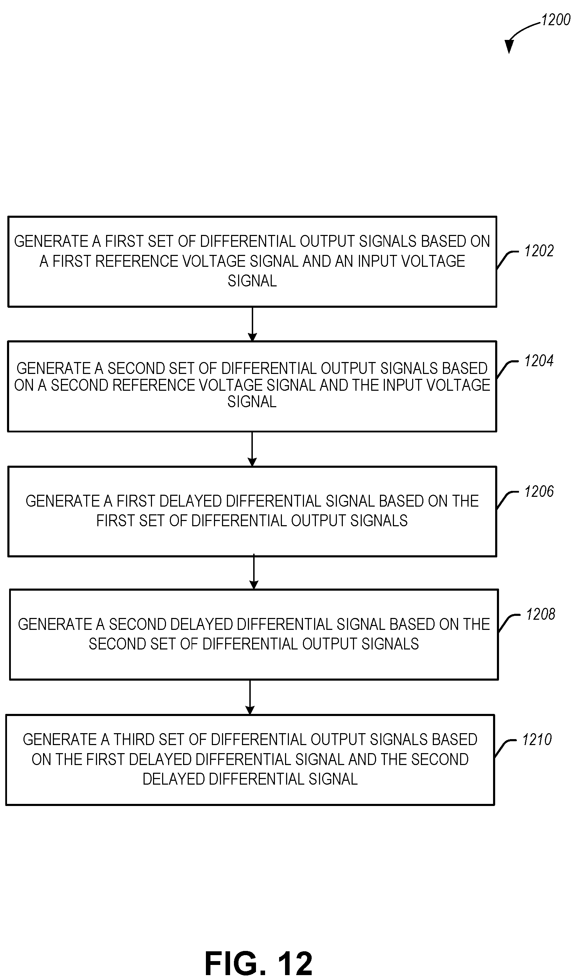

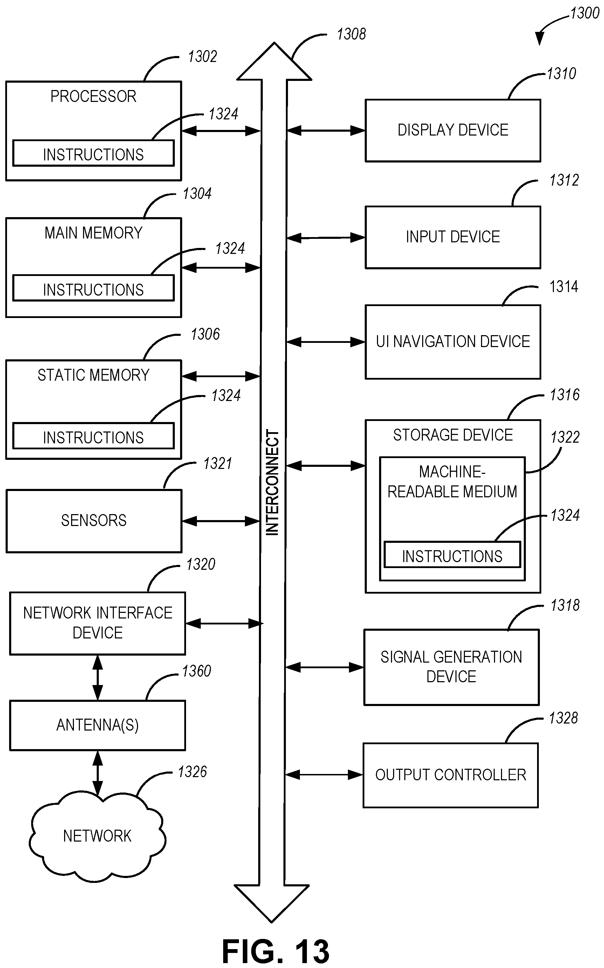

FIG. 12 is a flow diagram of an example method 1200 for generating differential output signals by an interpolation slice of an ADC, in accordance with some embodiments. Referring to FIG. 12, method 1200 includes operations 1202, 1204, 1206, 1208, and 1210, which may be executed by an ADC circuit, an embedded controller, or another processor of a computing device (e.g., hardware processor 1302 of machine 1300 illustrated in FIG. 13, which can include one or more of the circuits discussed in connection with FIGS. 1-11). In some embodiments, one or more of the circuits discussed in connection with FIGS. 1-11 can perform the functionalities listed in FIG. 12, as well as in the examples listed below.

The following example operations can be configured based on the description of FIG. 2B and FIG. 3.

At operation 1202, a first set of differential output signals is generated (e.g., by comparator 304)based on a first reference voltage signal (e.g., Vref1) and an input voltage signal (e.g., Vin).

At operation 1204, a second set of differential output signals is generated (e.g., by comparator 302) based on a second reference voltage signal (e.g., Vref2) and the input voltage signal.

At operation 1206, a first delayed differential signal is generated based on the first set of differential output signals (e.g., the output of the adjustable delay circuit 312).

At operation 1208, a second delayed differential signal is generated based on the second set of differential output signals (e.g., the output of the adjustable delay circuit 310).

At operation 1210, a third set of differential output signals is generated based on the first delayed differential signal and the second delayed differential signal (e.g., differential output signals 322 generated by the interpolation circuit 306).

FIG. 13 illustrates a block diagram of an example machine 1300 upon which any one or more of the techniques (e.g., methodologies) discussed herein may perform. In alternative embodiments, the machine 1300 may operate as a standalone device or may be connected (e.g., networked) to other machines. In a networked deployment, machine 1300 may operate in the capacity of a server machine, a client machine, or both in server-client network environments. In an example, machine 1300 may function as a peer machine in a peer-to-peer (P2P) (or other distributed) network environment. The machine 1300 may be a personal computer (PC), a tablet PC, a set-top box (STB), a personal digital assistant (PDA), a portable communications device, a mobile telephone, a smartphone, a web appliance, a network router, switch or bridge, or any other computing device capable of executing instructions (sequential or otherwise) that specify actions to be taken by that machine. Further, while only a single machine is illustrated, the term "machine" shall also be taken to include any collection of machines that individually or jointly execute a set (or multiple sets) of instructions to perform any one or more of the methodologies discussed herein, such as cloud computing, software as a service (SaaS), other computer cluster configurations. The terms "machine," "computing device," and "computer system" are used interchangeably.

Machine (e.g., computer system) 1300 may include a hardware processor 1302 (e.g., a central processing unit (CPU), a graphics processing unit (GPU), a hardware processor core, or any combination thereof), a main memory 1304, and a static memory 1306, some or all of which may communicate with each other via an interlink (e.g., bus) 1308. In some aspects, the main memory 1304, the static memory 1306, or any other type of memory (including cache memory) used by machine 1300 can be configured based on the disclosed techniques or can implement the disclosed memory devices.

Specific examples of main memory 1304 include Random Access Memory (RAM) and semiconductor memory devices, which may include, in some embodiments, storage locations in semiconductors such as registers. Specific examples of static memory 1306 include non-volatile memory, such as semiconductor memory devices (e.g., Electrically Programmable Read-Only Memory (EPROM), Electrically Erasable Programmable Read-Only Memory (EEPROM)) and flash memory devices; magnetic disks, such as internal hard disks and removable disks; magneto-optical disks; RAM; and CD-ROM and DVD-ROM disks.

Machine 1300 may further include a display device 1310, an input device 1312 (e.g., a keyboard), and a user interface (UI) navigation device 1314 (e.g., a mouse). In an example, the display device 1310, the input device 1312, and the UI navigation device 1314 may be a touchscreen display. The machine 1300 may additionally include a storage device (e.g., drive unit or another mass storage device) 1316, a signal generation device 1318 (e.g., a speaker), a network interface device 1320, and one or more sensors 1321, such as a global positioning system (GPS) sensor, compass, accelerometer, or other sensors. The machine 1300 may include an output controller 1328, such as a serial (e.g., universal serial bus (USB), parallel, or other wired or wireless (e.g., infrared (IR), near field communication (NFC), etc.) connection to communicate or control one or more peripheral devices (e.g., a printer, card reader, etc.). In some embodiments, the hardware processor 1302 and/or instructions 1324 may comprise processing circuitry and/or transceiver circuitry.

The storage device 1316 may include a machine-readable medium 1322 on which one or more sets of data structures or instructions 1324 (e.g., software) embodying or utilized by any one or more of the techniques or functions described herein can be stored. Instructions 1324 may also reside, completely or at least partially, within the main memory 1304, within static memory 1306, or the hardware processor 1302 during execution thereof by the machine 1300. In an example, one or any combination of the hardware processor 1302, the main memory 1304, the static memory 1306, or the storage device 1316 may constitute machine-readable media.

Specific examples of machine-readable media may include non-volatile memory, such as semiconductor memory devices (e.g., EPROM or EEPROM) and flash memory devices; magnetic disks, such as internal hard disks and removable disks; magneto-optical disks; RAM; and CD-ROM and DVD-ROM disks.

While the machine-readable medium 1322 is illustrated as a single medium, the term "machine-readable medium" may include a single medium or multiple media (e.g., a centralized or distributed database and/or associated caches and servers) configured to store instructions 1324.

An apparatus of machine 1300 may be one or more of a hardware processor 1302 (e.g., a central processing unit (CPU), a graphics processing unit (GPU), a hardware processor core, or any combination thereof), a main memory 1304 and a static memory 1306, one or more sensors 1321, a network interface device 1320, one or more antennas 1360, a display device 1310, an input device 1312, a UI navigation device 1314, a storage device 1316, instructions 1324, a signal generation device 1318, and an output controller 1328. The apparatus may be configured to perform one or more of the methods and/or operations disclosed herein. The apparatus may be intended as a component of machine 1300 to perform one or more of the methods and/or operations disclosed herein and/or to perform a portion of one or more of the methods and/or operations disclosed herein. In some embodiments, the apparatus may include a pin or other means to receive power. In some embodiments, the apparatus may include power conditioning hardware.

The term "machine-readable medium" may include any medium that is capable of storing, encoding, or carrying instructions for execution by machine 1300 and that causes machine 1300 to perform any one or more of the techniques of the present disclosure or that is capable of storing, encoding, or carrying data structures used by or associated with such instructions. Non-limiting machine-readable medium examples may include solid-state memories and optical and magnetic media. Specific examples of machine-readable media may include non-volatile memory, such as semiconductor memory devices (e.g., Electrically Programmable Read-Only Memory (EPROM), Electrically Erasable Programmable Read-Only Memory (EEPROM)) and flash memory devices; magnetic disks, such as internal hard disks and removable disks; magneto-optical disks; Random Access Memory (RAM); and CD-ROM and DVD-ROM disks. In some examples, machine-readable media may include non-transitory machine-readable media. In some examples, machine-readable media may include machine-readable media that is not a transitory propagating signal.

The instructions 1324 may further be transmitted or received over a communications network 1326 using a transmission medium via the network interface device 1320 utilizing any one of several transfer protocols (e.g., frame relay, internet protocol (IP), transmission control protocol (TCP), user datagram protocol (UDP), hypertext transfer protocol (HTTP), etc.). Example communication networks may include a local area network (LAN), a wide area network (WAN), a packet data network (e.g., the Internet), mobile telephone networks (e.g., cellular networks), Plain Old Telephone (POTS) networks, and wireless data networks (e.g., Institute of Electrical and Electronics Engineers (IEEE) 802.11 family of standards known as Wi-Fi^{®}, IEEE 802.16 family of standards known as WiMax^{®}), IEEE 802.15.4 family of standards, a Long Term Evolution (LTE) family of standards, a Universal Mobile Telecommunications System (UMTS) family of standards, peer-to-peer (P2P) networks, among others.

In an example, the network interface device 1320 may include one or more physical jacks (e.g., Ethernet, coaxial, or phone jacks) or one or more antennas to connect to the communications network 1326. In an example, the network interface device 1320 may include one or more antennas 1360 to wirelessly communicate using at least one single-input multiple-output (SIMO), multiple-input multiple-output (MIMO), or multiple-input single-output (MISO) techniques. In some examples, the network interface device 1320 may wirelessly communicate using multiple-user MIMO techniques. The term "transmission medium" shall be taken to include any intangible medium that can store, encode, or carry instructions for execution by the machine 1300 and includes digital or analog communications signals or other intangible media to facilitate communication of such software.

Examples, as described herein, may include, or may operate on, logic or several components, modules, or mechanisms. Modules are tangible entities (e.g., hardware) capable of performing specified operations and may be configured or arranged in a particular manner. In an example, circuits may be arranged (e.g., internally or concerning external entities such as other circuits) in a specified manner as a module. In an example, the whole or part of one or more computer systems (e.g., a standalone, client, or server computer system) or one or more hardware processors may be configured by firmware or software (e.g., instructions, an application portion, or an application) as a module that operates to perform specified operations. In an example, the software may reside on a machine-readable medium. In an example, the software, when executed by the underlying hardware of the module, causes the hardware to perform the specified operations.

Accordingly, the term "module" is understood to encompass a tangible entity, be that an entity that is physically constructed, specifically configured (e.g., hardwired), or temporarily (e.g., transitorily) configured (e.g., programmed) to operate in a specified manner or to perform part, all, or any operation described herein. Considering examples in which modules are temporarily configured, each of the modules need not be instantiated at any one moment in time. For example, where the modules comprise a general-purpose hardware processor configured using the software, the general-purpose hardware processor may be configured as respective different modules at separate times. The software may accordingly configure a hardware processor, for example, to constitute a particular module at one instance of time and to constitute a different module at a different instance of time.

Some embodiments may be implemented fully or partially in software and/or firmware. This software and/or firmware may take the form of instructions contained in or on a non-transitory computer-readable storage medium. Those instructions may then be read and executed by one or more processors to enable the performance of the operations described herein. The instructions may be in any suitable form, such as but not limited to source code, compiled code, interpreted code, executable code, static code, dynamic code, and the like. Such a computer-readable medium may include any tangible non-transitory medium for storing information in a form readable by one or more computers, such as but not limited to read-only memory (ROM), random access memory (RAM), magnetic disk storage media, optical storage media, flash memory, etc.

The above-detailed description includes references to the accompanying drawings, which form a part of the detailed description. The drawings show, by way of illustration, specific embodiments that may be practiced. These embodiments are also referred to herein as "examples." Such examples may include elements in addition to those shown or described. However, examples that include the elements shown or described are also contemplated. Moreover, also contemplated are examples using any combination or permutation of those elements shown or described (or one or more aspects thereof), either with respect to a particular example (or one or more aspects thereof) or with respect to other examples (or one or more aspects thereof) shown or described herein.

Publications, patents, and patent documents referred to in this document are incorporated by reference herein in their entirety, as though individually incorporated by reference. In the event of inconsistent usage between this document and those documents so incorporated by reference, the usage in the incorporated reference(s) is supplementary to that of this document; for irreconcilable inconsistencies, the usage in this document controls.

In this document, the terms "a" or "an" are used, as is common in patent documents, to include one or more than one, independent of any other instances or usages of "at least one" or "one or more." In this document, the term "or" is used to refer to a nonexclusive or, such that "A or B" includes "A but not B," "B but not A," and "A and B," unless otherwise indicated. In the appended claims, the terms "including" and "in which" are used as the plain-English equivalents of the respective terms "comprising" and "wherein." Also, in the following claims, the terms "including" and "comprising" are open-ended, that is, a system, device, article, or process that includes elements in addition to those listed after such a term in a claim are still deemed to fall within the scope of that claim. Moreover, in the following claims, the terms "first," "second," and "third," etc., are used merely as labels and are not intended to suggest a numerical order for their objects.

The embodiments as described above may be implemented in various hardware configurations that may include a processor for executing instructions that perform the techniques described. Such instructions may be contained in a machine-readable medium such as a suitable storage medium or a memory or other processor-executable medium.

The embodiments as described herein may be implemented in several environments, such as part of a system on chip, a set of intercommunicating functional blocks, or similar, although the scope of the disclosure is not limited in this respect.

Described implementations of the subject matter can include one or more features, alone or in combination, as illustrated below by way of examples.

Example 1 is an analog-to-digital converter (ADC) circuit comprising a first comparator circuit including a first input terminal to receive a first reference voltage signal and a second input terminal to receive an input voltage signal; a second comparator circuit including a first input terminal to receive a second reference voltage signal and a second input terminal to receive the input voltage signal; and an interpolation circuit including a first input terminal coupled to a first output terminal of the first comparator and a second input terminal coupled to a first output terminal of the second comparator.

In Example 2, the subject matter of Example 1 includes a first adjustable delay circuit, including an input terminal coupled to the first output terminal of the first comparator and an output terminal coupled to the first input terminal of the interpolation circuit.

In Example 3, the subject matter of Example 2 includes a second adjustable delay circuit, including an input terminal coupled to the first output terminal of the second comparator and an output terminal coupled to the second input terminal of the interpolation circuit.

In Example 4, the subject matter of Examples 1-3 includes subject matter where the interpolation circuit further comprises a first NAND gate, including a first input terminal coupled to the first input terminal of the interpolation circuit.

In Example 5, the subject matter of Example 4 includes subject matter where the interpolation circuit further comprises a second NAND gate, including a first input terminal coupled to an output terminal of the first NAND gate.

In Example 6, the subject matter of Example 5 includes subject matter where a second input terminal of the first NAND gate is coupled to an output terminal of the second NAND gate, and a second input terminal of the second NAND gate is coupled to the second input terminal of the interpolation circuit.

In Example 7, the subject matter of Examples 1-6 includes subject matter where the first comparator comprises a clock terminal to receive a clock signal.

In Example 8, the subject matter of Example 7 includes subject matter where the second comparator comprises a clock terminal to receive the clock signal.

In Example 9, the subject matter of Examples 1-8 includes subject matter where the interpolation circuit is an SR latch.

In Example 10, the subject matter of Examples 1-9 includes a processor, wherein the processor includes one or more of the first comparator circuit, the second comparator circuit, and the interpolation circuit.

In Example 11, the subject matter of Examples 1-10 includes one or more interconnects coupling two or more of the first comparator circuit, the second comparator circuit, and the interpolation circuit.

Example 12 is a method comprising generating a first set of differential output signals based on a first reference voltage signal and an input voltage signal, generating a second set of differential output signals based on a second reference voltage signal and the input voltage signal, generating a first delayed differential signal based on the first set of differential output signals; generating a second delayed differential signal based on the second set of differential output signals; and generating a third set of differential output signals based on the first delayed differential signal and the second delayed differential signal.

In Example 13, the subject matter of Example 12 includes generating the first set of differential output signals based on a comparison between the first reference voltage signal and the input voltage signal.

In Example 14, the subject matter of Example 13 includes generating the second set of differential output signals based on a comparison between the second reference voltage signal and the input voltage signal.

In Example 15, the subject matter of Examples 12-14 includes subject matter where generating the first delayed differential signal comprises selecting a first differential output signal from the first set of differential output signals and applying a first delay to the first differential output signal to generate the first delayed differential signal.

In Example 16, the subject matter of Example 15 includes configuring the first delay based on the first delayed differential signal being centered between the first reference voltage signal and the second reference voltage signal.

In Example 17, the subject matter of Examples 15-16 includes subject matter where generating the second delayed differential signal comprises selecting a second differential output signal from the second set of differential output signals and applying a second delay to the second differential output signal to generate the second delayed differential signal.

In Example 18, the subject matter of Example 17 includes configuring the second delay based on the second delayed differential signal being centered between the first reference voltage signal and the second reference voltage signal.

Example 19 is an apparatus comprising a reference voltage signal source, a clock signal source, and a plurality of interpolation slices coupled to the clock signal source and the reference voltage signal source. Each interpolation slice of the plurality of interpolation slices generates a first set of differential output signals based on a first reference voltage signal from the reference voltage signal source and an input voltage signal; generates a second set of differential output signals based on a second reference voltage signal from the reference voltage source and the input voltage signal; and generate a third set of differential output signals based on the first set of differential output signals and the second set of differential output signals.

In Example 20, the subject matter of Example 19 includes subject matter where the interpolation slice comprises a first comparator circuit to generate the first set of differential output signals based on a comparison of the first reference voltage signal and the input voltage signal.

In Example 21, the subject matter of Example 20 includes subject matter where the interpolation slice comprises a second comparator circuit to generate the second set of differential output signals based on a comparison of the second reference voltage signal and the input voltage signal.

In Example 22, the subject matter of Example 21 includes subject matter where the interpolation slice comprises a first adjustable delay circuit to generate a first delayed differential signal based on the first set of differential output signals.

In Example 23, the subject matter of Example 22 includes subject matter where the interpolation slice comprises a second adjustable delay circuit to generate a second delayed differential signal based on the second set of differential output signals.

In Example 24, the subject matter of Example 23 includes subject matter where the interpolation slice comprises an interpolation circuit to generate the third set of differential output signals based on the first delayed differential signal and the second delayed differential signal.

In Example 25, the subject matter of Example 24 includes a processor, wherein the processor includes at least one of the first comparator circuit, the second comparator circuit, the first adjustable delay circuit, the second adjustable delay circuit, and the interpolation circuit.

In Example 26, the subject matter of Examples 24-25 includes one or more interconnects coupling two or more of the first comparator circuit, the second comparator circuit, the first adjustable delay circuit, the second adjustable delay circuit, and the interpolation circuit.

In Example 27, the subject matter of any of Examples 1-26 includes a serializer/deserializer (SerDes)-based system including the disclosed ADC circuit, processor, or apparatus discussed herein.

Example 27 is at least one machine-readable medium including instructions that, when executed by processing circuitry, cause the processing circuitry to perform operations to implement any of Examples 1-26.

Example 28 is an apparatus comprising means to implement any of Examples 1-26.

Example 29 is a system to implement any of Examples 1-26.

Example 30 is a method to implement any of Examples 1-26.

In Example 31, the subject matter of Example 1 includes subject matter where the interpolation circuit is coupled to a serial data link associated with a serializer/deserializer (SerDes) based device.

The above description is intended to be illustrative and not restrictive. For example, the above-described examples (or one or more aspects thereof) may be used in combination with others. Other embodiments may be used, such as by one of ordinary skill in the art upon reviewing the above description. The abstract is to allow the reader to ascertain the nature of the technical disclosure quickly. It is submitted with the understanding that it will not be used to interpret or limit the scope or meaning of the claims. Also, in the above Detailed Description, various features may be grouped to streamline the disclosure. However, the claims may not set forth every feature disclosed herein as embodiments may feature a subset of said features. Further, embodiments may include fewer features than those disclosed in a particular example. Thus, the following claims are hereby incorporated into the Detailed Description, with a claim standing on its own as a separate embodiment. The scope of the embodiments disclosed herein is to be determined regarding the appended claims, along with the full scope of equivalents to which such claims are entitled.

## Claims

1. An analog-to-digital converter (ADC) circuit comprising:
a first comparator circuit including a first input terminal to receive a first reference voltage signal and a second input terminal to receive an input voltage signal;
a second comparator circuit including a first input terminal to receive a second reference voltage signal and a second input terminal to receive the input voltage signal; and
an interpolation circuit including a first input terminal coupled to a first output terminal of the first comparator and a second input terminal coupled to a first output terminal of the second comparator.

2. The ADC circuit of claim 1, further comprising:
a first adjustable delay circuit including an input terminal coupled to the first output terminal of the first comparator and an output terminal coupled to the first input terminal of the interpolation circuit.

3. The ADC circuit of claim 2, further comprising:
a second adjustable delay circuit including an input terminal coupled to the first output terminal of the second comparator and an output terminal coupled to the second input terminal of the interpolation circuit.

4. The ADC circuit of any of claims 1-3, wherein the interpolation circuit further comprises:
a first NAND gate including a first input terminal coupled to the first input terminal of the interpolation circuit.

5. The ADC circuit of claim 4, wherein the interpolation circuit further comprises:
a second NAND gate including a first input terminal coupled to an output terminal of the first NAND gate.

6. A method comprising:
generating a first set of differential output signals based on a first reference voltage signal and an input voltage signal;
generating a second set of differential output signals based on a second reference voltage signal and the input voltage signal;
generating a first delayed differential signal based on the first set of differential output signals;
generating a second delayed differential signal based on the second set of differential output signals; and
generating a third set of differential output signals based on the first delayed differential signal and the second delayed differential signal.

7. The method of claim 6, further comprising:
generating the first set of differential output signals based on a comparison between the first reference voltage signal and the input voltage signal.

8. The method of claim 7, further comprising:
generating the second set of differential output signals based on a comparison between the second reference voltage signal and the input voltage signal.

9. The method of any of claims 6-8, wherein generating the first delayed differential signal comprises:
selecting a first differential output signal from the first set of differential output signals; and
applying a first delay to the first differential output signal to generate the first delayed differential signal.

10. The method of claim 9, further comprising:
configuring the first delay based on the first delayed differential signal being centered between the first reference voltage signal and the second reference voltage signal.

11. An apparatus comprising:
a reference voltage signal source;
a clock signal source; and
a plurality of interpolation slices coupled to the clock signal source and the reference voltage signal source, each interpolation slice of the plurality of interpolation slices to:
generate a first set of differential output signals based on a first reference voltage signal from the reference voltage signal source and an input voltage signal;
generate a second set of differential output signals based on a second reference voltage signal from the reference voltage source and the input voltage signal; and
generate a third set of differential output signals based on the first set of differential output signals and the second set of differential output signals.

12. The apparatus of claim 11, wherein the interpolation slice comprises:
a first comparator circuit to generate the first set of differential output signals based on a comparison of the first reference voltage signal and the input voltage signal.

13. The apparatus of claim 12, wherein the interpolation slice comprises:
a second comparator circuit to generate the second set of differential output signals based on a comparison of the second reference voltage signal and the input voltage signal.

14. The apparatus of claim 13, wherein the interpolation slice comprises:
a first adjustable delay circuit to generate a first delayed differential signal based on the first set of differential output signals.

15. The apparatus of claim 14, wherein the interpolation slice comprises:
a second adjustable delay circuit to generate a second delayed differential signal based on the second set of differential output signals.
